# EUROPÄISCHE PATENTSCHRIFT

(11) **EP 1 396 180 B1**
(45) Veröffentlichungstag und Bekanntmachung des Hinweises auf die Patenterteilung: **12.12.2007**
(21) Anmeldenummer: 02737818.1
(22) Anmeldetag: 25.04.2002
(51) Int. Cl.: H05K 5/00

(54) **GEHÄUSE FÜR EIN ELEKTRISCHES GERÄT**
HOUSING FOR AN ELECTRIC DEVICE
BOITIER POUR APPAREIL ELECTRIQUE

(30) Priorität: 27.04.2001 DE 10120715
(43) Veröffentlichungstag der Anmeldung: 10.03.2004
(73) Patentinhaber: ROBERT BOSCH GMBH, 70442 Stuttgart (DE)
(72) Erfinder: JAKOB, Gert, 70378 Stuttgart (DE); BOHMWETSCH, Gerd, 71672 Marbach (DE); ECKERT, Bernd, 71665 Vaihingen/Enz (DE)
(86) Internationale Anmeldenummer: PCT/DE2002/001516
(87) Internationale Veröffentlichungsnummer: WO 2002/089547

(56) Entgegenhaltungen:
- EP-A- 0 712 265
- WO-A-92/11745
- DE-A- 19 541 925
- DE-C- 19 709 243
- DE-U- 20 012 623
- US-A- 5 253 143

## Beschreibung

### Stand der Technik

Die Erfindung betrifft ein Gehäuse für ein elektrisches Gerät, insbesondere ein elektronisches Steuer- oder Regelgerät für eine elektromechanische Anordnung, nach dem Oberbegriff des Hauptanspruchs.

Bei der Herstellung solcher Gehäuse für ein elektrisches Gerät, insbesondere zur Steuerung elektromechanischer Anordnungen beispielsweise im Kraftfahrzeug, muss beachtet werden, dass sowohl eine dichte Verbindung der Gehäuseteile als auch eine gute elektromagnetische Abschirmung (EMV) für die Steuergeräteelektronik bei möglichst geringem Herstellungsaufwand erreichbar ist.

Es ist bereits aus der DE-OS 39 37 190 ein elektrisches Gerät bekannt, bei dem die Steuergeräteelektronik für Komponenten eines Verbrennungsmotor in einem Gehäuse angeordnet ist, das im Bereich der Motoraggregate angebracht ist. Das zweiteilige Gehäuse aus Metall lässt sich elektromagnetisch abgeschirmt verschließen, wobei in das Gehäuse eine Anschlussvorrichtung für Verbindungsleitungen integriert ist über die die Spannungsversorgung und die Übertragung von Mess- und Steuersignalen möglich ist.

Aus der DE 42 43 180 A1 ist ein mehrteiliges Gehäuse für Steuergeräte bekannt, bei dem zur Erzielung einer ausreichenden Störstrahldichte und guter Wärmeableitung eine die Leistungsbauelemente und Steuerbauelemente tragende Leiterplatte mit einer umlaufenden Kaschierung aus elektrisch und wärmeleitendem Material versehen ist. Die Leiterplatte wird hier im Bereich dieser Kaschierungen, die miteinander elektrisch leitend verbunden sind, zwischen den Gehäusehälften eingespannt, wobei die Leistungsbauelemente wärmeleitend mit dieser Kaschierung kontaktiert sind. Störstrahlintensive oder - empfindliche Steuerelemente sind dabei von aus der Wand der Gehäuseteile vorstehenden Stutzen eingeschlossen.

Weiterhin ist es bekannt, dass bei einigen Steuergerätegehäusen durch den Einbau eines sogenannten Masseblechs die Öffnung für die Steckerleiste in der Anschlussvorrichtung des Gehäuses gegenüber hochfrequenter Störstrahlung abgedichtet wird. Damit entsteht trotz der Verwendung von nichtleitenden Werkstoffen für den Steckerleistenisolierkörper näherungsweise ein Faradayscher Käfig, durch den sowohl unerwünschte Einstrahlungen als auch Abstrahlungen wirksam unterdrückt werden können. Die Kontaktierung dieser Massebleche zur Steuergerätemasse erfordert allerdings Geometrien, die das Abdichten der Gehäuse sehr schwierig machen. Die mechanische Festigkeit des Gehäuses im Bereich der Steckerleistenöffnung muss dabei durch eine Vergrößerung der Wandstärke der umliegenden Wände des Gehäuses sichergestellt werden.

### Vorteile der Erfindung

Das eingangs beschriebene Gehäuse mit mindestens zwei Gehäuseteilen und einer im Gehäuse anordbaren Leiterplatte sowie einer am Gehäuse befestigbaren Anschlussvorrichtung ist erfindungsgemäß mit den kennzeichnenden Merkmalen des Anspruchs 1 weitergebildet. In vorteilhafter Weise ist gemäß der Erfindung eine mit einem Gehäuseteil einstückig verbundene Gehäusewand vorhanden, mit der nach dem Zusammenfügen der Gehäuseteile sowohl für dichte und undichte Geräte eine störstrahlungssichere Kammer zur Aufnahme der Anschlussvorrichtung gebildet ist.

Die mechanische Versteifung des Gehäuses durch die erfindungsgemäße Gehäusewand ermöglicht dabei außerdem die Wandstärkenoptimierung der umliegenden Gehäusewände. Die durch die erfindungsgemäße Gehäusewand geschlossene Steckerleistenöffnung muss dann nicht mehr durch eine mechanische Verstärkung der umliegenden Wände stabilisiert werden.

Bevorzugt weist das erfindungsgemäße Gehäuse mindestens ein elektrisch leitendes Kontaktelement zwischen der Gehäusewand der Kammer und mit einem Massenschluss des Gehäuses verbundenen Leiterbahnen der Leiterplatte auf. Durch den Einsatz der Gehäusewand in Verbindung mit dem oder den Kontaktelementen lassen sich auf einfache Weise sowohl mechanisch undichte als auch abgedichtete Geräte, insbesondere für eine Steuer- und/oder Regelanordnung für ein elektromechanisches Bauteil in einem Kraftfahrzeug, unabhängig von der Form der Steckerleiste in der Anschlussvorrichtung auch mit einem hochfrequenzdichten Käfig ausrüsten. Hierbei sind insbesondere Frequenzen im GHz-Bereich, wie sie z.B. im Mobilfunk verwendet werden, mit Wellenlängen kleiner als 50 cm zu berücksichtigen. Eine ausreichende elektromagnetische Abschirmung ist erst dann gewährleistet, wenn Öffnungen und insbesondere Spalte deutlich kleiner als die Wellenlänge der einstrahlenden Störstrahlungen sind. Dabei ist insbesondere auch die Längenabmessung von Spalten zu berücksichtigen. Die vorteilhafte Ausgestaltung der Gehäusewand mit einem Kontaktelement erlaubt es nun, die elektromagnetische Strahlung im Bereich des Kontaktelementes auf die Gehäusemasse zu leiten, und so die effektiv wirksame Spaltlänge zu reduzieren. Durch die Anordnung mehrerer Kontaktelemente werden die Spaltlängen weiter verringert und somit die elektromagnetische Verträglichkeit hin zu höheren Frequenzen verbessert.

Vorteilhaft kann auch zwischen dem Deckel und der Leiterplatte ein Kontaktelement vorgesehen sein. Hierdurch wird auch auf der Oberseite der Leiterplatte ein elektromagnetisch geschützter Bereich aufgebaut und ermöglicht die Anordnung von Bauelementen auch in diesem Bereich.

Als Kontaktelemente können vorteilhaft flexible Federelemente eingesetzt werden. Sie ermöglichen eine leichte und schnelle Montage, kleine Veränderung in der Spalthöhe können ausgeglichen werden.

Des weiteren können vorteilhaft Fortsätze an der Gehäusewand und/oder dem Deckel vorgesehen sein, so dass eine elektrische Kontaktierung ohne weitere Kontaktelemente oder mit einfachen Kontaktelementen erfolgen kann.

In einer weiteren Ausführung können die Fortsätze als Aufnahme für Kontaktelemente, insbesondere Kontaktfedern dienen. Hierdurch können die Vorteile eines mechanisch stabilen Fortsatzes und eines Kontaktelements miteinander kombiniert werden. Die Spalthöhe wird so im Wesentlichen durch die Fortsätze überbrückt und die Kontaktierung erfolgt über ein beispielsweise flexibles Kontaktelement.

In vorteilhafter Weise können die Spalthöhen so gewählt werden, dass im Spaltbereich Bauelemente angeordnet sind. Dies ermöglicht mehr Freiheiten beim Schaltungsdesign.

Insbesondere sind im Spaltbereich Kondensatoren vorteilhaft anzuordnen, die Störungen von außerhalb des elektromagnetisch geschützten Bereichs entkoppeln können.

Vorteilhaft ist die Gehäusewand einstückig mit dem Gehäuseteil verbunden. So kann die Gehäusewand z.B. in einem Druckguss-Verfahren, gleichzeitig in einem Arbeitsschritt mit dem Gehäuseteil gefertigt werden. Das einstückige Einbringen der Gehäusewand versteift gleichzeitig das Gehäuse und erlaubt es die Gehäusewandstärken zu verringern ohne Stabilität zu verlieren.

Vorteilhaft ist das Gehäuse in Aluminiumdruckguss ausgeführt. Dies erlaubt eine einfache Herstellung eines stabilen, leitfähigen und gut wärmeleitfähigen Gehäuses.

Diese und weitere Merkmale von bevorzugten Weiterbildungen der Erfindung gehen außer aus den Ansprüchen, einschließlich der rückbezogenen Unteransprüche, auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ein Ausführungsbeispiel eines Gehäuses für ein elektrisches Gerät mit zwei Gehäuseteilen wird anhand der Zeichnung erläutert. Es zeigen:
Figur 1 eine schematische Ansicht eines Gehäuseteils mit einer zusätzlichen Gehäusewand zur Bildung einer störstrahlungsdichten Kammer für ein Steckerteil,
Figur 2 eine Vorderansicht auf die Kammer des Gehäuseteils nach der Figur 1 mit einer Leiterplatte und
Figur 3 einen Schnitt durch den Bereich des Gehäuses mit der Kammer und der Leiterplatte sowie mit einem Kontaktelement zwischen der Gehäusewand und der Leiterplatte.
Figur 4 einen schematischen Schnitt längs der Gehäusewand.

### Beschreibung des Ausführungsbeispiels

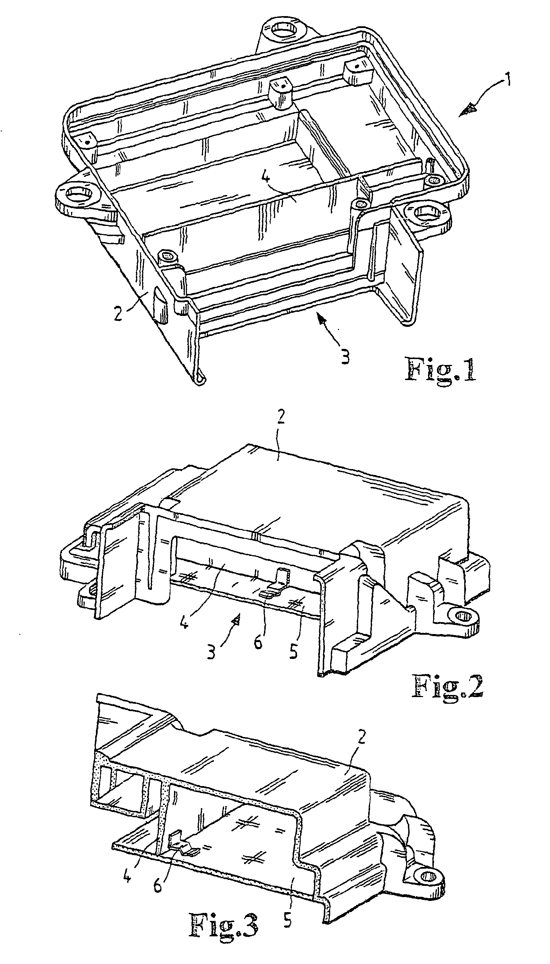

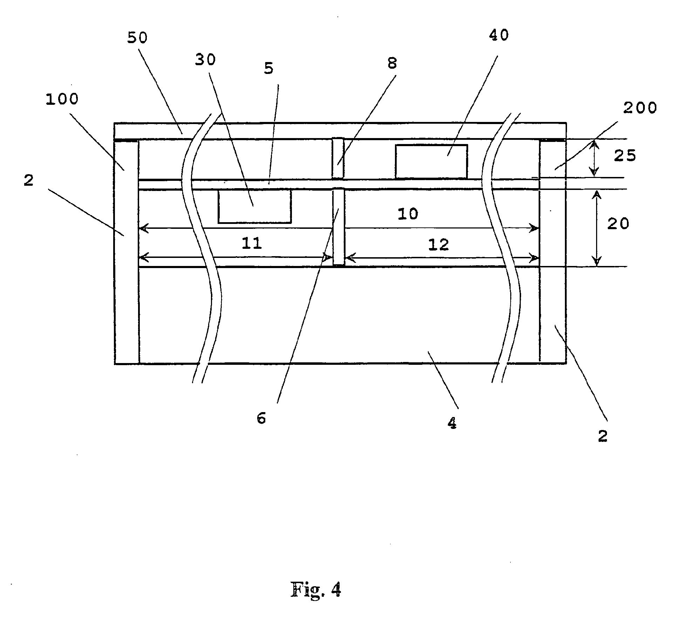

In Figur 1 ist ein Gehäuse 1 für ein elektrisches Steuergerät gezeigt, das ein oberes hier nicht sichtbares Gehäuseteil, in Figur 4 als Deckel 50 dargestellt, und ein unteres Gehäuseteil 2, beispielsweise aus Aluminiumguss, aufweist. Am Gehäuse 1 und somit auch am unteren Gehäuseteil 2 kann in einer entsprechenden Ausformung 3 eine Anschlussvorrichtung in Form eines Steckerteils angefügt werden, welches Steckkontakte für die Spannungsversorgung oder zur Kontaktierung von Signalleitungen für das Steuergerät aufweist.

Im Gehäuseteil 2 ist eine Gehäusewand 4 erkennbar, die beim Urformen des Gehäuses 1 mitgegossen werden kann und die Aufgabe hat, hinter dem Steckerteil das Gehäuse 1 so abzuschließen, dass ein sogenannter Faradayscher Käfig entstehen kann. Die Gehäusewand 4 verstärkt dabei das Gehäuse 1 derart, dass auch eine Wandstärkenoptimierung der anderen Gehäusewände des Gehäuses 1 möglich wird.

Aus Figur 2 ist eine andere Ansicht des Gehäuses 1 bzw. des Gehäuseteils 2 nach der Figur 1 auf die kammerartige Ausformung 3 mit der Gehäusewand 4 zur Aufnahme des Steckerteils sichtbar. Hier ist eine Leiterplatte 5 sichtbar, die die elektronische Schaltung für das elektrische Steuergerät im Gehäuse 1 trägt. Die Leiterplatte 5 überdeckt den gesamten Bereich der Gehäusewand 4 und wird von dem Gehäuseteil 2 eingefasst. Auf die Leiterplatte 5 ist hier mindestens ein Kontaktelement 6 aufgelötet und mit der Masse der Leiterplatte 5 verbunden.

Das Kontaktelement 6 nach der Figur 2 ist im Schnitt nach Figur 3 deutlicher zu erkennen und hat die Aufgabe, den zwischen der Gehäusewand 4 und der Leiterplatte 5 entstehenden Spalt elektrisch zu überbrücken und damit den Faradayschen Käfig vollständig abzuschließen. Die flexible Anordnung des Kontaktelements 6 bietet die Möglichkeit, die verbleibende Restspaltlänge einfach an die jeweils vorliegenden Erfordernisse anzupassen, wobei bei Bedarf das Kontaktelement 6 natürlich mehrfach eingesetzt werden kann.

Figur 4 zeigt einen Schnitt längs der Gehäusewand 4. Oberhalb der Gehäusewand 4 ist die Leiterplatte 5 angeordnet, wobei beide Elemente vom Gehäuseteil 2 umfasst werden. Oberhalb der Leiterplatte 5 befindet sich ein oberes Gehäuseteil welches aufgrund der obenliegenden Darstellung in der Figur 4 im Folgenden als Deckel 50 bezeichnet wird. In Abhängigkeit von der Einbaulage des Steuergeräts kann aber der "Deckel" natürlich auch ein "Boden" sein. Links und rechts der Anordnung befinden sich die Gehäuseseiten 100 und 200 des unteren Gehäuseteils 2. Zwischen Gehäusewand 4 und Leiterplatte 5 ist ein Kontaktelement 6 mittig angeordnet. Zwischen dem Deckel 50 und der Leiterplatte 5 ist ein Kontaktelement 8 mittig angeordnet. Auf der Leiterplatte 5 sind an der Unter- und Oberseite Bauelemente 30 und 40 vorgesehen. Die Spalthöhe 20 ergibt sich aus dem Abstand zwischen Gehäusewand 4 und der Leitplatte 5 und die Spalthöhe 25 aus dem Abstand zwischen der Leiterplatte 5 und dem Deckel 50. Zwischen den Gehäuseseiten 100 und 200 erstreckt sich die Spaltlänge 10. Die Restspaltlänge 11 bzw. 12 wird durch den Abstand zwischen dem Kontaktelement 6 und den Gehäuseseiten 100 und 200 bestimmt. Die Restspaltlängen für das Kontaktelement 8 ergeben sich in vergleichbarer Weise und sind nicht weiter dargestellt.

Dieser Aufbau hat den Vorteil, das durch die Kontaktelemente 6 und 8 auf beiden Seiten der Leiterplatte 5 elektromagnetisch geschützte Bereiche erzeugt werden. Durch die Anordnung weiterer Kontaktelemente 6, 8 können die Restspaltlängen verringert werden. Dies führt zu einer weiteren Verbesserung der elektromagnetische Verträglichkeit. Die Einführung von Kontaktelementen 6,8 ermöglicht es weiterhin die Spalthöhen 20, 25 schaltungstechnischen Gegebenheiten anzupassen. Insbesondere können im Spaltbereich Bauelemente vorgesehen sein, besonders vorteilhaft sind hier Kondensatoren zur Entkopplung von äußeren Störsignalen anzuordnen.

Die Kontaktelemente 6, 8 haben im Wesentlichen die Aufgabe die Spaltlänge dadurch zu verringern, indem die eindringende elektromagnetische Strahlung im Bereich des Kontaktelementes auf Gehäusemasse geleitet wird. Ist die verbleibende Restspaltlänge kleiner als die Wellenlänge der einstrahlenden elektromagnetischen Welle, wird die weitere Ausbreitung gedämpft und die hinter dieser Anordnung befindlichen Bauelemente werden elektromagnetisch geschützt. Um diese Aufgabe zu erfüllen, muss das Kontaktelement metallisch ausgeführt sein. Vorzugsweise kann hier ein flexibles Federelement vorgesehen sein. Es sind aber auch einstückig mit der Gehäusewand 4 und/oder Deckel 50 verbundene Fortsätze denkbar. Diese Fortsätze können entweder direkt mit einer Leiterbahn der Leiterplatte 5 verbunden sein oder ein flexibles Federelement zur Kontaktierung tragen. Die Fortsätze können auch so ausgeführt werden, dass jeweils ein Fortsatz des Deckels 50 einen Fortsatz der Gehäusewand 4 kontaktiert.

Desweiteren hat der Aufbau mit gegenüberliegenden Kontaktelementen den Vorteil, daß die mechanischen Belastungen auf Gehäusewand und Leiterplatte ausgeglichen werden, die beim Einsatz eines einzelnen Kontaktelements auftreten.

## Patentansprüche

1. Elektrisches Gerät mit einem Gehäuse, mit
- mindestens zwei metallischen Gehäuseteilen (2) und einer im Gehäuse (1) angeordneten elektronischen Schaltung auf einer Leiterplatte (5) und mit
- einer am Gehäuse (1) befestigten Anschlussvorrichtung für die Spannungsversorgung des Geräts und/oder die Signalübertragung zu der elektronischen Schaltung, **wobei**
eine mit einem der metallischen Gehäuseteile (2) mechanisch und elektrisch verbundene leitende Gehäusewand (4) vorhanden ist, mit der nach dem Zusammenfügen der metallischen Gehäuseteile (2) eine störstrahlungssichere kammerartige Ausformung (3) zur Aufnahme der Anschlussvorrichtung gebildet ist,
**dadurch gekennzeichnet, dass** mindestens ein elektrisch leitendes Kontaktelement (6) zwischen der Gehäusewand (4) der Kammer (3) und den mit einem Massenschluss des Gehäuses verbundenen Leiterbahnen der Leiterplatte (5) angeordnet ist.

2. Gerät nach einem der vorhergehenden Ansprüche,
**dadurch gekennzeichnet, dass** mindestens ein Kontaktelement (8) zwischen einem Deckel (50) und Leiterbahnen der Leiterplatte (5) angeordnet ist, wobei die Leiterbahnen mit einem Massenschluss des Gehäuses verbunden sind.

3. Gerät nach einem der vorhergehenden Ansprüche,
**dadurch gekennzeichnet, dass** die Kontaktelemente (6), (8) als Kontaktfedern ausgeführt sind.

4. Gerät nach einem der vorhergehenden Ansprüche,
**dadurch gekennzeichnet, dass** die Gehäusewand (4) und/oder der Deckel (50) jeweils wenigstens einen einstückig verbundenen Fortsatz aufweisen.

5. Gerät nach einem der vorhergehenden Ansprüche,
**dadurch gekennzeichnet, dass** die Gehäusewand (4) und/oder der Deckel (50) jeweils wenigstens einen einstückig verbundenen Fortsatz aufweisen, an dem ein elektrisch leitendes Kontaktelement (6), (8) befestigt ist.

6. Gerät nach einem der vorhergehenden Ansprüche,
**dadurch gekennzeichnet, dass** die Spalthöhen 20 und 25 so eingestellt sind, dass die Anordnung von Bauelementen 30 und 40 im Spaltbereich möglich ist.

7. Gerät nach einem der vorhergehenden Ansprüche,
**dadurch gekennzeichnet, dass** im Spaltbereich Kondensatoren angeordnet sind.

8. Gerät nach einem der vorhergehenden Ansprüche,
**dadurch gekennzeichnet, dass** die Gehäusewand (4) einstückig mit dem Gehäuseteil (2) verbunden ist.

9. Gerät nach einem der vorhergehenden Ansprüche,
**dadurch gekennzeichnet, dass** das Gehäuse (1), das Gehäuseteil (2), der Deckel (50) und die Gehäusewand (4) aus Aluminiumdruckguss gefertigt ist.

10. Gerät nach einem der vorhergehenden Ansprüche, **dadurch gekennzeichnet, dass**
- das elektrische Gerät eine Steuer- und/oder Regelanordnung für ein elektromechanisches Bauteil in einem Kraftfahrzeug ist.

## Claims

1. Electrical device having a housing, comprising
- at least two metal housing parts (2) and an electronic circuit, which is arranged in the housing (1), on a printed circuit board (5), and comprising
- a connection apparatus, which is fastened to the housing (1), for the voltage supply of the device and/or the signal transmission to the electronic circuit, wherein a conductive housing wall (4) which is mechanically and electrically connected to one of the metal housing parts (2) is provided, with which an interfering radiation-proof chamber-like shaped area (3) is formed in order to accommodate the connection apparatus after the metal housing parts (2) are joined, **characterized in that** at least one electrically conductive contact element (6) is arranged between the housing wall (4) of the chamber (3) and the conductor tracks of the printed circuit board (5) which are connected to an earth connection of the housing.

2. Device according to Claim 1, **characterized in that** at least one contact element (8) is arranged between a cover (50) and conductor tracks of the printed circuit board (5), wherein the conductor tracks are connected to an earth connection of the housing.

3. Device according to either of the preceding claims, **characterized in that** the contact elements (6), (8) are designed as contact springs.

4. Device according to one of the preceding claims, **characterized in that** the housing wall (4) and/or the cover (50) each have at least one integrally connected projection.

5. Device according to one of the preceding claims, **characterized in that** the housing wall (4) and/or the cover (50) each have at least one integrally connected projection to which an electrically conductive contact element (6), (8) is fastened.

6. Device according to one of the preceding claims, **characterized in that** the gap heights 20 and 25 are set such that it is possible to arrange components 30 and 40 in the gap region.

7. Device according to one of the preceding claims, **characterized in that** capacitors are arranged in the gap region.

8. Device according to one of the preceding claims, **characterized in that** the housing wall (4) is integrally connected to the housing part (2).

9. Device according to one of the preceding claims, **characterized in that** the housing (1), the housing part (2), the cover (50) and the housing wall (4) are produced from die-cast aluminium.

10. Device according to one of the preceding claims, **characterized in that**
- the electrical device is an open-loop and/or closed-loop control arrangement for an electromechanical component in a motor vehicle.

## Revendications

1. Appareil électrique comportant un boîtier avec
- au moins deux parties métalliques (2) et un circuit électronique sur une plaque conductrice (5) logée dans le boîtier (1) ainsi qu'un
- dispositif de branchement fixé au boîtier (1) pour l'alimentation en tension de l'appareil et/ou la transmission des signaux vers le circuit électronique,
appareil dans lequel
une paroi de boîtier (4) reliée mécaniquement et de façon électro-conductrice à la partie métallique (2) du boîtier, et qui après assemblage des parties métalliques de boîtier (2), constitué une cavité en forme de chambre (3) blindée, pour recevoir le dispositif de branchement,
**caractérisé en ce qu'**
au moins un élément de contact (6) électro-conducteur est prévu entre la paroi (4) du boîtier de la chambre (3) et les chemins conducteurs de la plaque de circuit (15), reliés à la borne de masse du boîtier.

2. Appareil selon l'une des revendications précédentes,
**caractérisé par**
au moins un élément de contact (8) entre un couvercle (50) et les chemins conducteurs de la plaque de circuit (5), les chemins conducteurs étant reliés à la borne de masse du boîtier.

3. Appareil selon l'une des revendications précédentes,
**caractérisé en ce que**
les éléments de contact (6, 8) sont des ressorts de contact.

4. Appareil selon l'une des revendications précédentes,
**caractérisé en ce que**
la paroi de boîtier (4) et/ou le couvercle (50) comportent chacun au moins un prolongement faisant corps.

5. Appareil selon l'une des revendications précédentes,
**caractérisé en ce que**
la paroi de boîtier (4) et/ou le couvercle (50) ont chacun au moins un prolongement faisant corps auquel est fixé un élément de contact électro-conducteur (6, 8).

6. Appareil selon l'une des revendications précédentes,
**caractérisé en ce que**
les hauteurs (20, 25) des intervalles sont réglées pour permettre l'installation de composants (30) et (40) dans la zone de l'intervalle.

7. Appareil selon l'une des revendications précédentes,
**caractérisé en ce que**
des condensateurs sont prévus dans la zone de l'intervalle.

8. Appareil selon l'une des revendications précédentes,
**caractérisé en ce que**
la paroi de boîtier (4) est reliée en une seule pièce à la partie de boîtier (2).

9. Appareil selon l'une des revendications précédentes,
**caractérisé en ce que**
le boîtier (1), la partie de boîtier (2), le couvercle (50) et la paroi de boîtier (4) sont fabriqués en fonte d'aluminium.

10. Appareil selon l'une quelconque des revendications précédentes,
**caractérisé en ce que**
l'appareil électrique est un dispositif de commande et/ou de régulation d'un composant électromécanique d'un véhicule automobile.
